# EUROPÄISCHE PATENTSCHRIFT

(11) **EP 1 062 851 B1**
(45) Veröffentlichungstag und Bekanntmachung des Hinweises auf die Patenterteilung: **24.10.2001**
(21) Anmeldenummer: 99915509.6
(22) Anmeldetag: 08.03.1999
(51) Int. Cl.: H05K 7/14, G05B 19/02

(54) **MODULARE LEISTUNGSENDSTUFE**
MODULAR POWER OUTPUT STAGE
ETAGE MODULAIRE DE SORTIE DE PUISSANCE

(30) Priorität: 12.03.1998 DE 19810842
(43) Veröffentlichungstag der Anmeldung: 27.12.2000
(73) Patentinhaber: ROBERT BOSCH GMBH, 70442 Stuttgart (DE)
(72) Erfinder: WEBER, Rupert, D-63936 Schneeberg (DE)
(86) Internationale Anmeldenummer: DE9900612
(87) Internationale Veröffentlichungsnummer: WO9946967

(56) Entgegenhaltungen:
- DE-A- 19 631 894
- JP-A- 8 256 499
- US-A- 5 493 194
- PATENT ABSTRACTS OF JAPAN vol. 096, no. 012, 26. Dezember 1996 (1996-12-26) & JP 08 213105 A (NEC CORP), 20. August 1996 (1996-08-20)

## Beschreibung

### Stand der Technik

Die Erfindung betrifft eine modulare Leistungsendstufe zur Ansteuerung mehrerer elektrischer Achsantriebsmotoren mehrachsiger Maschinen (vgl- z.B. JP-A-08256499), insbesondere Werkzeugmaschinen, Roboterantriebe, Verpackungsmaschinen ....

Gewöhnlich werden zum Antrieb von elektrischen Achsantriebsmotoren solcher mehrachsigen Maschinen Umrichter verwendet, die eine Leistungsendstufe enthalten. Bei solchen Umrichtern stellt die Leistungsendstufe einen Hauptkostenfaktor dar.

Für eine auf die Leistungsanforderungen der verschiedenen Achsantriebsmotoren mehrachsiger Maschinen kostenoptimierte Leistungsendstufe kann man die bekannte Modultechnik einsetzen, bei der für jeden Motor ein eigenes, leistungsmäßig angepaßtes Endstufen- oder Achsmodul zur Verfügung gestellt wird.

Weitere Kostenreduzierungen bei der Ansteuerung mehrer elektrischer Achsantriebsmotoren sind unter anderem durch das Zusammenfassen von Funktionen und mechanischen Teilen zu erreichen. Der Nachteil hierbei ist, daß für jeden unterschiedlichen Anwendungsfall die Leistungsendstufe anders gestaltet sein muß, wenn ein Optimum an Leistung/Kosten erreicht werden soll. Dies ist besonders bei großen Stückzahlen je Variante, bei der die Rüst-, Prüf-, Fertigungskosten usw. eine untergeordnete Rolle spielen, kein Problem.

### Vorteile der Erfindung

Die Aufgabe der Erfindung besteht somit darin, eine Lösung für einen, bei kleinen Losgrößen und unterschiedlichen Anwendungsfällen sehr flexiblen und auch bei sehr kleinen Durchlaufzeiten hinsichtlich der Kosten optimierten Kompaktumrichter für Mehrachsanwendungen, d.h. für mehrere elektrische Achsantriebsmotoren mehrachsiger Maschinen zu ermöglichen, bei dem möglichst viele vorgefertigte gleiche Teile eingesetzt werden können.

Die obige Aufgabe wird erfindungsgemäß gelöst durch eine modulare Leistungsendstufe zur Ansteuerung mehrerer elektrischer Achsantriebsmotoren mehrachsiger Maschinen, insbesondere Werkzeugmaschinen, die dadurch gekennzeichnet ist, daß die mehreren, hinsichtlich ihrer Leistung an den jeweils anzusteuernden Motor angepaßten Endstufenmodule auf einem gemeinsamen oder jeweils auf einzelnen auf einer eine Montageebene bildenden oder angebenden Ebene angeordneten Kühlkörper(n) angebracht sind, der bzw. die mechanisch an jedem Platz für unterschiedliche Leistungsvarianten der Endstufenmodule vorbereitet ist bzw. sind, und daß Mittel zur kodierten Kontaktierung wenigstens der Eingangsanschlüsse jedes Endstufenmoduls vorgesehen sind, wobei jede Leistungsvariante der Endstufenmodule räumlich unterschiedlich angeordnete Anschlüsse hat.

Mit diesen Bauteilen und einer fertig vorproduzierten Ansteuerschaltungsgruppe läßt sich sehr schnell und flexibel ein an unterschiedliche Kundenanforderungen angepaßter Mehrachsumrichter bauen.

In einem sehr späten Fertigungsschritt wird erst die Achs-Leistungszuordnung getroffen. D.h., daß die entsprechend der Leistung notwendigen Halbleitermodule der Endstufe zunächst auf ihren Platz montiert werden, darauf die Ansteuerschaltungsgruppe montiert wird und dann die Anpassung der Ansteuerung und Spannung über die kodierte Kontaktierung ohne weitere Veränderungen erfolgt.

Die kodierten Kontaktierungen sind erfindungsgemäß wenigstens für die Steuereingänge angeordnet.

Ferner können auch die Leistungseingänge kodiert, d.h. räumlich unterschiedlich entsprechend der Spannungsklasse des jeweiligen Endstufenmoduls angeordnet sein.

Besonders bevorzugt sind alle Kontaktierungen der jeweiligen Endstufenmodule lötfreie Kontaktierungen.

### Zeichnung

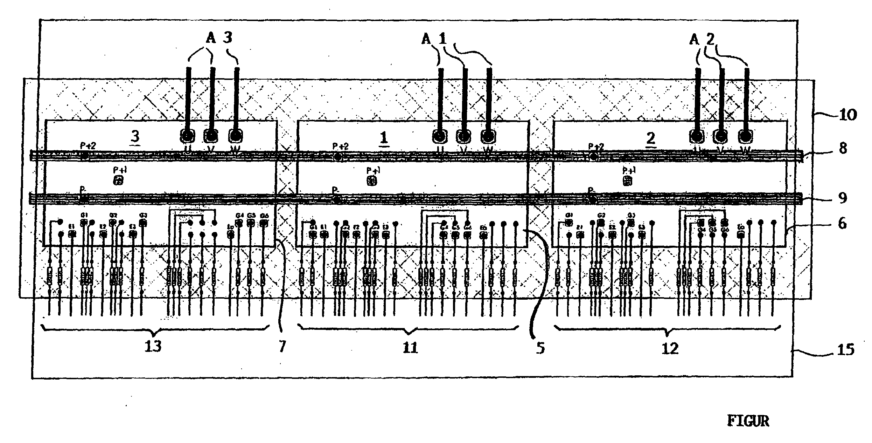

Die obigen und weitere Merkmale und Vorteile der Erfindung werden in der nachfolgenden, ein Ausführungsbeispiel beschreibenden Beschreibung deutlich, wenn diese zusammen mit der beiliegenden einzigen Zeichnungsfigur gelesen wird.

Die Figur zeigt in einer schematischen Draufsicht eine erfindungsgemäß gestaltete modulare Leistungsendstufe, die beispielhaft drei modulare Leistungsendstufen oder Umrichterstufen aufweist.

### Ausführungsbeispiel

Die in der Figur schematisch gezeigte erfindungsgemäße Ausführungsform einer modularen Leistungsendstufe weist drei Endstufenmodule oder Umrichtermodule 1, 2, 3 auf, die gemeinsam auf einem durchgehenden, durch Kreuzschraffur hervorgehobenen Kühlkörper 10 montiert sind. Der Kühlkörper 10 bildet entweder selbst die Montageebene oder definiert diese. Die in der Figur nach unten weisenden Steuereingänge 11, 12, 13 der Module 1, 2, 3 sind mit Mitteln zur kodierten Kontaktierung für die jeweiligen Steuereingänge 11, 12 und 13 versehen, die zu einer mit 15 bezeichneten Leiterplatte mit Ansteuerschaltgruppen führen.

Der Kühlkörper 10 ist mechanisch an jedem Montageplatz für eine unterschiedliche Leistungsmodulvariante vorbereitet. Das betrifft die Bohrlöcher, Schraubgewinde und ähnliche Mittel. Die Leistungsendstufenmodule 1, 2, 3 selbst sind vorteilhafterweise für lötfreie Kontaktierung konstruiert. Alternativ kann dies auch mit (nicht gezeigten) Standardmodulen und aufgebrachtem (nicht gezeigtem) Adapter erreicht werden. Die lötfreien, kodiert angeordneten Kontaktierungen 5, 6, 7 der Steuereingänge 11, 12, 13 sind so angeordnet, daß jede Leistungsendstufenvariante räumlich unterschiedlich angeordnete Steueranschlüsse (wie z.B. Gate-Emitter, Basis-Emitter, ...).

Mit 8 und 9 bezeichnete Spannungsschienen für die Leistungszufuhr, z.B. Zwischenkreisanschlüsse, sind bevorzugt ebenfalls räumlich unterschiedlich je Spannungsklasse angeordnet In dem in der Figur dargestellten Beispiel hat jedes Leistungsendstufenmodul zwei lötfreie kodierte Leistungseingänge. Im dargestellten Beispiel sind die Spannungsschienen 8 und 9 jeweils mit den Leistungseingängen P+2 und P- jedes Moduls verbunden.

Jedes Modul hat zwei (lötfreie) kodierte Leistungseingänge, z.B. für die eine Spannungsklasse sind dies P+1 und P-. Es können natürlich auch alle drei Anschlüsse auf dem Modul vorhanden sein. Die Kodierung erfolgt dann durch die unterschiedliche Belegung innerhalb des Moduls. Dadurch wird erreicht, daß innerhalb einer Umrichterkonfiguration mit unterschiedlichen Zwischenkreisspannungen und somit unterschiedlichen Motoren bezüglich der Spannung gearbeitet werden kann.

Femer weist jedes Leistungsendstufenmodul in der Figur nach oben geführte dreiphasige Ausgangsanschlüsse U, V, W auf, die bevorzugt ebenfalls lötfrei ausgeführt sind.

Die zugehörige, auf der Leiterplatte 15 aufgebrachte, Ansteuerschaltung ist mit allen Varianten bestückt, was in der Regel pro Stufe und Variante einen vemachlässigbaren Mehraufwand von ein bis zwei Widerständen bedeutet.

Mit den oben erwähnten Merkmalen und der fertig auf der gedruckten Leiterplatte vorproduzierten Ansteuerschaltungsgruppe läßt sich sehr schnell und flexibel ein an die entsprechende Kundenanforderung angepaßter Mehrachsumrichter bauen.

In einem späteren Fertigungsschritt wird die Achsantriebsmotor-Leistungszuordnung getroffen. D.h., daß die notwendigen Endstufenmodule bzw. Halbleiterpackungen auf ihrem Platz montiert werden, die Ansteuerschaltungsgruppe darauf montiert wird und die Anpassung der Ansteuerung und der Spannung über die oben erwähnten Kodierungen der lötfreien Anschlüsse ohne weitere Veränderungen erfolgt.

Ein weiterer Kostenvorteil kann erreicht werden, wenn der mechanische Aufbau die Gleichteile, wie Hauptnetzteil, Ein- und Ausgänge, Bremschopper ..., mitberücksichtigt.

Selbstverständlich ist die Erfindung nicht auf das oben beschriebene und in der Figur dargestellte Ausführungsbeispiel beschränkt. Insbesondere können auch mehr als drei Leistungsendstufenmodule auf einem gemeinsamen Kühlkörper oder auf in einer gemeinsamen Ebene liegenden getrennten Kühlkörpern montiert sein. Die in der Figur gezeigte Kodierung der Kontaktierung ist auch lediglich beispielhaft.

## Patentansprüche

1. Modulare Leistungsendstufe zur Ansteuerung mehrerer elektrischer Achsantriebsmotoren mehrachsiger Maschinen, insbesondere Werkzeugmaschinen,
**dadurch gekennzeichnet, daß** die mehreren, hinsichtlich ihrer Leistung an den jeweils anzusteuernden Motor angepaßten Endstufenmodule (1, 2, 3) auf einem gemeinsamen oder jeweils auf einzelnen auf einer eine Montageebene bildenden oder angebenden Ebene angeordneten Kühlkörper(n) (10) angebracht sind, der bzw. die mechanisch an jedem Platz für unterschiedliche Leistungsvarianten der Endstufenmodule (1, 2, 3) vorbereitet ist bzw. sind, und daß Mittel (5, 6, 7) zur kodierten Kontaktierung wenigstens der Eingangsanschlüsse jedes Endstufenmoduls (1, 2, 3) vorgesehen sind, wobei jede Leistungsvariante der Endstufenmodule räumlich unterschiedlich angeordnete Anschlüsse hat.

2. Modulare Leistungsendstufe nach Anspruch 1, **dadurch gekennzeichnet, daß** die kodierten Kontaktierungen für die Steuereingänge angeordnet sind.

3. Modulare Leistungsendstufe nach Anspruch 1 oder 2, **dadurch gekennzeichnet, daß** auch die Leistungseingänge kodiert, d.h. räumlich unterschiedlich entsprechend der Spannungsklasse des jeweiligen Endstufenmoduls (1, 2, 3) angeordnet sind.

4. Modulare Leistungsendstufe nach einem der Ansprüche 1 bis 3,
**dadurch gekennzeichnet, daß** alle Kontaktierungen der jeweiligen Endstufenmodule lötfreie Kontaktierungen sind.

5. Modulare Leistungsendstufe nach einem der Ansprüche 1 bis 4,
**dadurch gekennzeichnet, daß** die Ausgangsanschlüsse (U, V, W) jedes Endstufenmoduls (1, 2, 3) dreiphasig sind.

6. Verfahren zur fertigungstechnischen Konfektionierung einer modularen Leistungsendstufe nach einem oder mehreren der Ansprüche 1 bis 5, **dadurch gekennzeichnet, daß**
a) die für die jeweiligen Achsantriebsmotoren notwendigen Endstufenmodule (1, 2, 3) auf ihren, durch die Ebene des durch den oder die Kühlkörper definierten Montageplatz montiert werden,
b) eine Ansteuerschaltung (15), die mit allen für die Endstufenmodule vorkommenden Schaltungsvarianten bestückt ist, auf die Endstufenmodule (1, 2, 3) montiert wird, und
c) die Anpassung der Ansteuerung (15), der Leistungs- und Spannungsklasse der Endstufenmodule über die kodierten lötfreien Anschlußkontakte (5, 6, 7) der Endstufenmodule erfolgt.

## Claims

1. Modular power output stage for driving a number of electrical shaft drive motors for multi-shaft machines, in particular machine tools,
**characterized in that** the number of output stage modules (1, 2, 3) whose power is matched to the respective motor to be driven are mounted on a common heat sink (10) or each mounted on individual heat sinks (10) which is or are arranged on a plane which forms or indicates a mounting plane, and the heat sink or heat sinks (10) is or are provided mechanically at each location for different power variants of the output stage modules (1, 2, 3), and **in that** means (5, 6, 7) are provided for making coded contact with at least the input connections of each output stage module (1, 2, 3), with each power variant of the output stage modules having connections arranged in a physically different manner.

2. Modular power output stage according to Claim 1, **characterized in that** the coded contacts are arranged for the control inputs.

3. Modular power output stage according to Claim 1 or 2, **characterized in that** the power inputs are also coded, that is to say they are arranged in a physically different manner corresponding to the voltage class of the respective output stage module (1, 2, 3).

4. Modular power output stage according to one of Claims 1 to 3, **characterized in that** all the contacts of the respective output stage modules are solder-free contacts.

5. Modular power output stage according to one of Claims 1 to 4, **characterized in that** the output connections (U, V, W) of each output stage module (1, 2, 3) are three-phase.

6. Method for prefabrication, during production, of a modular power output stage according to one or more of Claims 1 to 5, **characterized in that**
a) the output stage modules (1, 2, 3) required for the respective shaft drive motors are mounted on their mounting location defined by the plane of the [lacuna] by the heat sink or heat sinks,
b) a drive circuit (15), which is fitted with all the circuit variants that occur for the output stage modules is mounted on the output stage modules (1, 2, 3) and
c) the matching of the drive (15) to the power and voltage class of the output stage modules is carried out via the coded solder-free connecting contacts (5, 6, 7) of the output stage modules.

## Revendications

1. Etage modulaire de sortie de puissance pour commander plusieurs moteurs électriques d'entraînement d'axes de machines à plusieurs axes, notamment de machines outils,
**caractérisé en ce que**
les différents modules d'étage de sortie (1, 2, 3) adaptés par leur puissance aux moteurs à commander, sont installés sur un organe de refroidissement (10) commun ou chaque fois sur des organes de refroidissement (10) formant un plan de montage ou des plans adjacents, ces éléments de refroidissement étant préparés mécaniquement à chaque endroit pour des variantes de puissance différentes des modules de sortie de puissance (1, 2, 3), et
des moyens (5, 6, 7) sont prévus pour la mise en contact codée au moins des bornes d'entrée de chaque module d'étage de puissance (1, 2, 3), chaque variante de puissance du module de l'étage d'entrée ayant des branchements disposés différemment.

2. Etage modulaire de sortie de puissance selon la revendication 1,
**caractérisé en ce que**
les contacts codés sont prévus pour les entrées de commande.

3. Etage modulaire de sortie de puissance selon les revendications 1 ou 2,
**caractérisé en ce que**
les entrées de puissance sont également codées, c'est-à-dire réparties différemment dans l'espace du point de vue de la classe de tension du module respectif de l'étage de sortie (1, 2, 3).

4. Etage modulaire de sortie de puissance selon l'une quelconque des revendications 1 à 3,
**caractérisé en ce que**
tous les contacts des modules d'étage de puissance respectifs sont des contacts sans soudure.

5. Etage modulaire de sortie de puissance selon l'une quelconque des revendications 1 à 4,
**caractérisé en ce que**
les bornes de sortie (U, V, W) de chaque module de sortie de puissance (1, 2, 3) sont triphasées.

6. Procédé pour réaliser en finition un étage de puissance modulaire de sortie selon l'une ou plusieurs des revendications 1 à 5,
**caractérisé en ce que**
a) les modules de sortie de puissance (1, 2, 3), nécessaires aux moteurs d'entraînement d'essieux respectifs, sont montés dans le plan de l'emplacement de mémoire défini pour le ou les organes de refroidissement,
b) un circuit de commande garni de toutes les variantes de circuit d'un module de sortie de puissance, est monté sur ces modules (1, 2, 3) et
c) l'adaptation de la commande (15), de la classe de puissance et de tension des modules de fin de puissance, se fait suivant le codage de contacts de branchement (5, 6, 7) codés sans soudure pour le module de l'étage de sortie.
